# FASCICULE DE BREVET EUROPEEN

(11) **EP 3 032 590 B1**
(45) Date de publication et mention de la délivrance du brevet: **05.07.2017**
(21) Numéro de dépôt: 15198227.9
(22) Date de dépôt: 07.12.2015
(51) Int. Cl.: H01L 31/02

(54) **PROCÉDÉ ET APPAREIL DE DÉTECTION D'UN DISPOSITIF DE PRODUCTION PHOTOVOLTAÏQUE D'ÉLECTRICITÉ DANS UN RÉSEAU DE DISTRIBUTION ÉLECTRIQUE, ET PRODUIT PROGRAMME D'ORDINATEUR ASSOCIÉ**
VERFAHREN UND VORRICHTUNG ZUR DETEKTIERUNG EINER PHOTOVOLTAISCHE ENERGIEERZEUGUNGSVORRICHTUNG IN EINEM ENERGIEVERSORGUNGSNETZWERK, UND COMPUTERPROGRAMM DAZU
METHOD AND DEVICE FOR DETECTING A PHOTOVOLTAIC POWER DEVICE IN A POWER DISTRIBUTION NETWORK, AND RELATED COMPUTER PROGRAMME PRODUCT

(30) Priorité: 08.12.2014 FR 1462074
(43) Date de publication de la demande: 15.06.2016
(73) Titulaire: Schneider Electric Industries SAS, 92500 Rueil-Malmaison (FR)
(72) Inventeur: BEDIOU, Stéphane, 38050 GRENOBLE Cedex 09ES (FR); CLOT, Sylvain, 38050 GRENOBLE Cedex 09 (FR); CLEMENCE, Michel, 38050 GRENOBLE Cedex 09 (FR); DESCHAMPS, Philippe, 38050 GRENOBLE Cedex 09 (FR)
(74) Mandataire: Lavoix

(56) Documents cités:
- US-A1- 2012 143 383
- US-A1- 2013 046 415

## Description

La présente invention concerne un procédé de détection d'un dispositif de production photovoltaïque d'électricité dans un réseau de distribution électrique, un produit programme d'ordinateur apte à mettre en oeuvre un tel procédé, ainsi qu'un appareil associé. Le document US2012/143383A décrit un système de détection pour un dispositif photovoltaïque. L'invention concerne le domaine des réseaux de transport et de distribution d'électricité. Ces réseaux comprennent typiquement un noeud central auquel sont rattachées par des conducteurs électriques un certain nombre d'installations électriques.

Le noeud central est, par exemple, un poste de transformation moyenne tension/basse tension (dit poste MT/BT), situé à l'interface entre un réseau de distribution à moyenne tension et le réseau de distribution à basse tension auxquels les installations électriques sont raccordées.

Les installations électriques sont par exemple des installations domestiques ou industrielles. Chaque installation comporte en général plusieurs dispositifs électriques. Ces dispositifs électriques comprennent des dispositifs consommateurs d'électricité et/ou des dispositifs producteurs d'électricité.

Un tel réseau de transport et de distribution connaît naturellement des fluctuations importantes de sa charge électrique, de par la variation de la consommation locale, mais également de par la variation de la production locale d'électricité. Cela est encore plus significatif suite au développement important ces dernières années des dispositifs de production d'électricité à partir d'énergies renouvelables, et principalement de la production photovoltaïque d'électricité. En effet, un grand nombre de dispositifs de production de faible puissance sont maintenant installés chez des particuliers ou des entreprises.

La gestion des charges électriques du réseau se fait par exemple par l'utilisation de charges pilotables, tel que cela est décrit dans la demande de brevet FR 2 980 946 A1, ou d'équipements de stockage. Il est donc nécessaire de bien connaître la composition du réseau électrique afin de pouvoir évaluer les variations attendues de la charge du réseau, et donc répartir et dimensionner au mieux ces dispositifs de gestion. C'est particulièrement nécessaire pour les installations de production photovoltaïque d'électricité, dont la production varie beaucoup en fonction de l'environnement extérieur.

Cependant, les dispositifs photovoltaïques de faible puissance sont en général reliés directement au réseau basse tension (BT), et ne sont pas nécessairement signalés au gestionnaire du réseau électrique. De plus, même dans le cas où ils seraient signalés au gestionnaire, celui-ci n'est pas nécessairement capable de localiser aisément le point de rattachement, au réseau, de l'installation comportant ledit dispositif photovoltaïque. En effet, les réseaux BT sont denses, fréquemment enterrés, et souvent soumis à des modifications parfois mal répertoriées.

Le but de l'invention est donc de proposer un procédé permettant de détecter un ou plusieurs dispositifs de production photovoltaïque d'électricité parmi plusieurs dispositifs électriques d'une installation reliée à un réseau de distribution électrique.

A cet effet, l'invention a pour objet un procédé de détection d'au moins un dispositif de production photovoltaïque d'électricité dans un réseau de distribution électrique comprenant au moins une installation électrique et au moins un capteur de courant, chaque installation comprenant au moins un dispositif électrique et étant reliée à un noeud de distribution respectif par au moins un conducteur électrique respectif, chaque capteur étant associé à un conducteur électrique respectif, ledit procédé comprenant les étapes suivantes :
i/ acquisition, de la part d'un capteur de courant, d'une pluralité de profils de puissance active d'une installation correspondante, chaque profil de puissance active comportant une pluralité de mesures de puissance active associées chacune à un instant temporel respectif d'une plage temporelle ;
ii/ calcul, pour au moins un couple de profils de puissance active, d'un profil différentiel comportant une pluralité de valeurs, chaque valeur du profil différentiel étant égale à la différence entre deux mesures respectives des profils de puissance active dudit couple ;
iii/ calcul d'un coefficient de corrélation entre le ou les profils différentiels calculés et un profil de référence correspondant à une production photovoltaïque d'électricité ;
iv/ détection de la présence d'un dispositif de production photovoltaïque d'électricité parmi le ou les dispositifs électriques de l'installation considérée lorsque le coefficient de corrélation est supérieur à une valeur prédéfinie.

Suivant d'autres aspects avantageux de l'invention, le procédé de détection comprend une ou plusieurs des caractéristiques suivantes, prises isolément ou selon toutes les combinaisons techniquement possibles :
- les plages temporelles respectives des profils de puissance active de chaque couple ont des durées sensiblement égales :
- l'étape ii/ comprend la sélection, parmi la pluralité de profils acquis, d'un couple de profils pour lesquels la consommation d'énergie électrique par l'installation considérée est sensiblement égale, d'un profil du couple à l'autre, pendant la plage temporelle de mesure de chacun des deux profils dudit couple, et le calcul du profil différentiel est effectué à partir du couple sélectionné de profils ;

- l'étape i/ comprend en outre l'acquisition d'une pluralité de profils de puissance réactive, chaque profil de puissance réactive comportant une pluralité de mesures de puissance réactive associées chacune à un instant temporel respectif de la plage temporelle d'un profil de puissance active correspondant, et le calcul à partir de chaque profil de puissance réactive de l'énergie réactive consommée pendant la plage temporelle correspondante, et dans lequel la sélection d'au moins un couple de profils effectuée lors de l'étape ii/ comprend la sélection d'un couple de profils pour lesquels la consommation totale d'énergie réactive correspondant à l'un des profils du couple est égale, à 10% près, à la consommation totale d'énergie réactive correspondant à l'autre profil du couple ;
- la plage temporelle correspondant à chaque profil de puissance active comprend une période diurne et une période nocturne, et la sélection d'au moins un couple de profils effectuée lors de l'étape ii/ comprend la sélection d'un couple de profils pour lesquels la consommation totale d'énergie active pendant la période nocturne correspondant à l'un des profils du couple est égale, à 10% près, à la consommation totale d'énergie active pendant la période nocturne correspondant à l'autre des profils du couple ;
- l'étape i/ comprend en outre l'acquisition d'une valeur d'ensoleillement lors de la mesure de chaque profil de puissance active, et l'étape ii/ comprend la sélection, parmi la pluralité de profils acquis de puissance active, d'au moins un couple de profils pour lesquels la valeur acquise d'ensoleillement diffère d'un profil à l'autre, et le calcul du profil différentiel est effectué à partir du couple sélectionné de profils ;
- l'étape ii/ comprend le calcul d'un profil différentiel pour chaque couple de profils de puissance active, et la sélection d'au moins un profil différentiel dont la valeur absolue maximale est supérieure à la moitié du maximum de l'ensemble des valeurs absolues des profils différentiels calculés, et lors de l'étape iii/, le calcul du coefficient de corrélation est effectué en fonction du ou des profils différentiels sélectionnés ;
- l'étape ii/ comprend le calcul d'au moins un profil différentiel pour chaque couple de profils de puissance active, et la sélection d'un profil différentiel dont la valeur absolue présente une valeur maximale pour un instant temporel compris entre deux instants temporels prédéfinis, et lors de l'étape iii/, le calcul du coefficient de corrélation est effectué en fonction du ou des profils différentiels sélectionnés ;
- lorsque plusieurs profils différentiels sont calculés lors de l'étape ii/, l'étape iii/ comprend en outre le calcul d'un profil différentiel moyen égal à une moyenne des profils différentiels calculés, et le coefficient de corrélation est calculé entre le profil différentiel moyen et le profil de référence correspondant à la production photovoltaïque d'électricité ;
- lors de l'étape i/, chaque profil de puissance active comporte des composantes fréquentielles, et les composantes fréquentielles de chaque profil de puissance active d'au moins un couple sont filtrées par un filtre passe-bas ayant une fréquence de coupure sensiblement égale à 3.10⁻⁴ Hz, et le calcul du profil différentiel est effectué à partir du couple filtré de profils ;
- le procédé comprend en outre une étape d'estimation de la puissance crête d'un dispositif de production photovoltaïque d'électricité détecté à partir du profil différentiel calculé ;
- les étapes i/ à iv/ sont réitérées à partir des profils de puissance active acquis de la part d'un autre capteur de courant.

L'invention a également pour objet un produit programme d'ordinateur comportant des instructions logicielles qui, lorsqu'elles sont exécutées par un ordinateur, mettent en oeuvre un procédé de détection tel que défini ci-dessus.

L'invention a également pour objet un appareil de détection d'au moins un dispositif de production photovoltaïque d'électricité dans un réseau de distribution électrique comprenant au moins une installation électrique et au moins un capteur de courant, chaque installation comprenant au moins un dispositif électrique et étant reliée à un noeud de distribution respectif par au moins un conducteur électrique respectif, chaque capteur étant associé à un conducteur électrique respectif, ledit appareil comportant
- un module d'acquisition configuré pour acquérir, de la part d'un capteur de courant, une pluralité de profils de puissance active d'une installation correspondante, chaque profil de puissance active comportant une pluralité de mesures de puissance active associées chacune à un instant temporel respectif d'une plage temporelle ;
- un module différentiel configuré pour calculer, pour au moins un couple de profils de puissance active, un profil différentiel comportant une pluralité de valeurs, chaque valeur du profil différentiel étant égale à la différence entre deux mesures respectives des profils de puissance active dudit couple;
- un module de corrélation configuré pour calculer un coefficient de corrélation entre le ou les profils différentiels calculés et un profil de référence correspondant à une production photovoltaïque d'électricité ; et
- un module de détection configuré pour détecter la présence d'un dispositif de production photovoltaïque d'électricité parmi le ou les dispositifs électriques de l'installation considérée lorsque le coefficient de corrélation est supérieur à une valeur prédéfinie.

Suivant un autre aspect avantageux de l'invention, l'appareil de détection comprend également un module d'estimation (30) configuré pour estimer la puissance crête d'un dispositif détecté de production photovoltaïque d'électricité à partir du profil différentiel calculé.Ces caractéristiques et avantages de l'invention apparaîtront à la lecture de la description qui va suivre, donnée uniquement à titre d'exemple non limitatif, et faite en référence aux dessins annexés, sur lesquels :

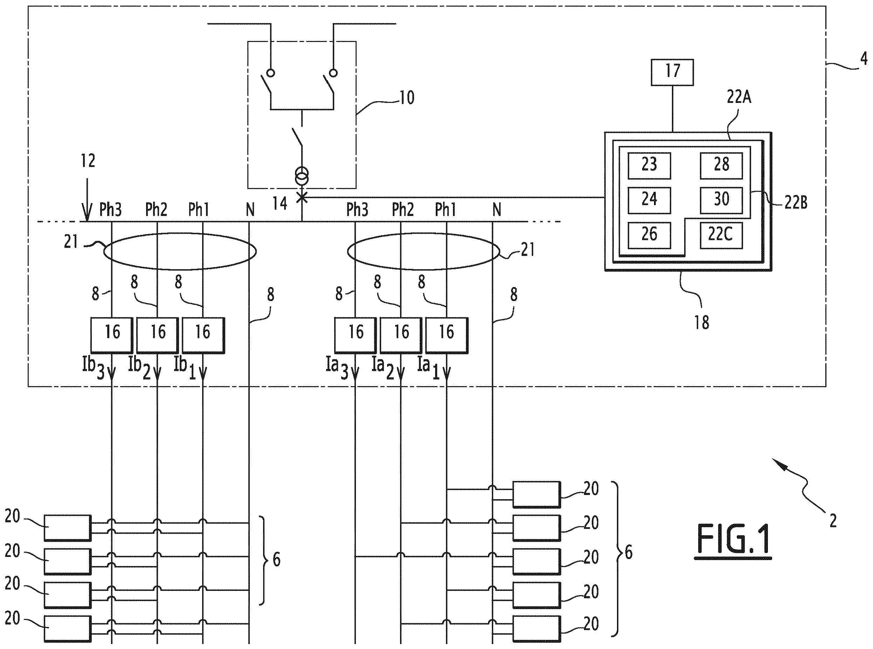

- la figure 1 est une vue schématique partielle d'un réseau de distribution électrique comportant deux installations électriques et une pluralité de capteurs de courant, chaque installation comprenant plusieurs dispositifs électriques et étant reliée à un noeud de distribution par au moins un conducteur électrique respectif, chaque capteur étant associé à un conducteur électrique respectif;

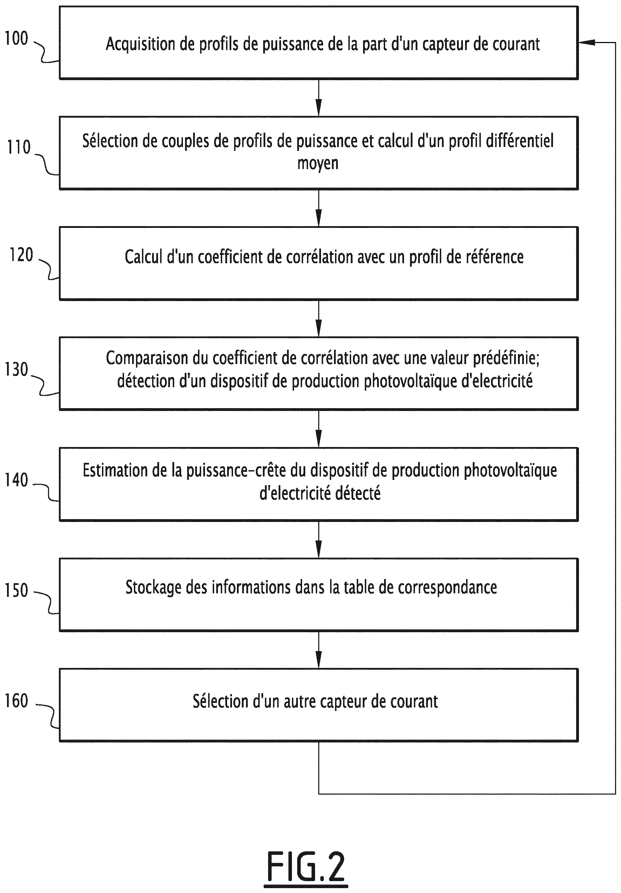

- la figure 2 est un organigramme d'un procédé de détection d'au moins un dispositif de production photovoltaïque d'électricité dans le réseau de la figure 1, le procédé comprenant une étape d'acquisition, de la part d'un capteur de courant, d'une pluralité de profils de puissance active d'une installation correspondante, chaque profil de puissance active comportant une pluralité de mesures de puissance active associées chacune à un instant temporel respectif d'une plage temporelle ;

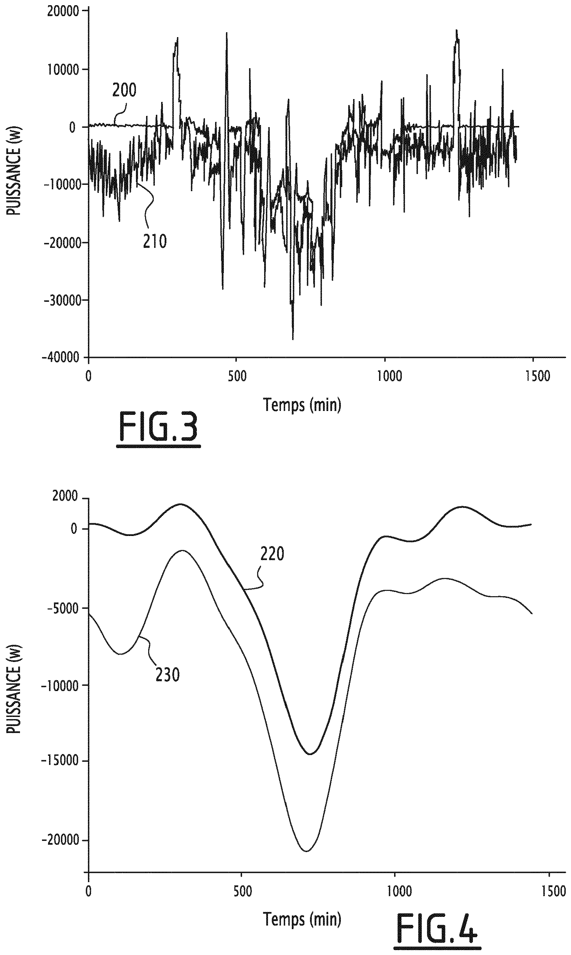

- la figure 3 est un exemple de deux profils différentiels calculés selon le procédé de la figure 2, chaque profil différentiel étant calculé à partir d'un couple de profils de puissance active et comportant une pluralité de valeurs, chaque valeur du profil différentiel étant égale à la différence entre deux mesures respectives;
- la figure 4 est un exemple de deux profils différentiels calculés selon le procédé de la figure 2 à partir de deux couples de profils de puissance active dont les composantes fréquentielles ont été filtrées par un filtre passe-bas ; et

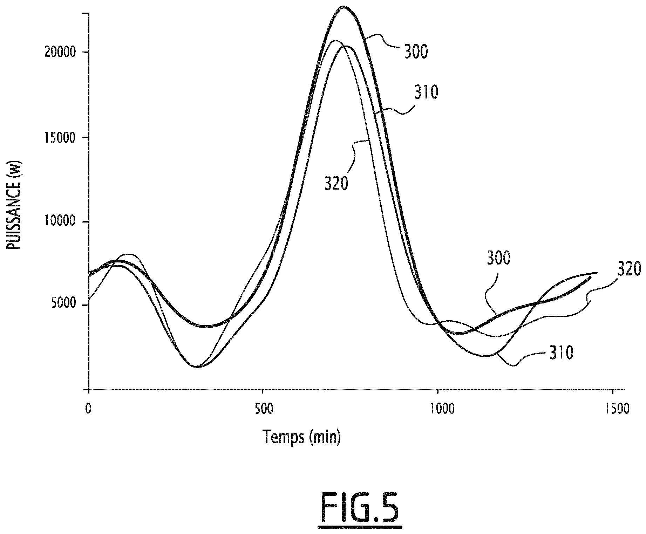

- la figure 5 est un exemple de trois profils différentiels sélectionnés parmi une pluralité de profils différentiels calculés selon le procédé de la figure 2, la valeur absolue de chaque profil différentiel sélectionné étant maximale pour un instant temporel compris entre deux instants temporels prédéfinis.

Dans la suite de la description, l'expression « sensiblement égal » définit une relation d'égalité à plus ou moins 10%.

Dans la suite de la description, par couple d'éléments, on entend un ensemble de deux éléments, ou encore une paire d'éléments.

Sur la figure 1, un réseau basse tension (BT) 2 de distribution d'électricité est représenté partiellement et schématiquement. Le réseau basse tension 2 comporte un poste de transformation 4 moyenne tension/basse tension (MT/BT), et une pluralité d'installations électriques 6. Chaque installation électrique 6 est reliée au poste de transformation 4 par au moins un conducteur électrique 8.

Le poste de transformation MT/BT 4 comprend un transformateur MT/BT 10, relié à un tableau 12 de répartition par un noeud 14. Le poste de transformation MT/BT 4 comporte en outre au moins un capteur de courant 16, et un appareil de détection 18. Sur la figure 1, le poste de transformation MT/BT 4 comporte six capteurs de courant 16, chacun étant associé à un conducteur de phase respectif.

En complément facultatif, le poste de transformation MT/BT 4 comporte un dispositif 17 de mesure de l'ensoleillement apte à communiquer à l'appareil de détection 18 une valeur d'ensoleillement au niveau du poste de transformation MT/BT 4.

Le poste de transformation MT/BT 4 est alimenté par un réseau moyenne tension de distribution (non représenté) et est apte à alimenter en basse tension les installations électriques 6. Par exemple, la moyenne tension est comprise entre 1 kV et 50 kV, et la basse tension est comprise entre 50 V et 1 kV.

Chaque installation électrique 6 comporte au moins un dispositif électrique 20. Le dispositif électrique 20 est par exemple un dispositif consommateur d'électricité, ou un dispositif producteur d'électricité, tel qu'un dispositif photovoltaïque de production d'électricité.

L'installation électrique 6 est par exemple globalement consommatrice d'électricité. En variante, l'installation électrique 6 produit plus d'électricité qu'elle n'en consomme, c'est-à-dire est globalement productrice d'électricité.

Sur la figure 1, deux installations électriques 6 et 6 ont été représentées. Chacune des deux installations électriques 6 comprend cinq dispositifs électriques 20.

Chaque conducteur électrique 8 est apte à transporter un courant électrique basse tension du poste de transformation MT/BT 4 à l'installation 6 correspondante.

Le tableau de répartition 12 reçoit du transformateur MT/BT 10 un courant basse tension, via le noeud 14. Le tableau de répartition 12 reçoit une extrémité de chaque conducteur électrique 8. Les conducteurs électriques 8 sont regroupés au niveau du tableau de répartition en un certain nombre de départs triphasés 21. Par exemple, le tableau de répartition 12 alimente entre 2 et 10 départs triphasés 21. Deux départs triphasés 21 ont été représentés sur la figure 1.

Chaque capteur de courant 16 est associé à un conducteur 8 correspondant. Le capteur de courant 16 est configuré pour mesurer à un instant temporel donné un courant circulant dans le conducteur 8 correspondant et communiquer la mesure de courant à l'appareil de détection 18.

De préférence, le capteur de courant 16 est apte à calculer la puissance active circulant dans le conducteur 8 correspondant à partir de la mesure du courant, et à communiquer la mesure de puissance active à l'appareil de détection 18. En complément facultatif, le capteur de courant 16 est en outre apte à calculer la puissance réactive circulant dans le conducteur 8 correspondant à partir de la mesure du courant, et à communiquer la mesure de puissance réactive à l'appareil de détection 18.

Le capteur de courant 16 est configuré pour mesurer aussi bien un courant circulant depuis le tableau 12 vers l'installation 6, qu'un courant circulant depuis l'installation 6 vers le tableau 12. Les mesures de puissance active prennent par exemple des valeurs positives lorsque l'installation 6 reliée au conducteur 8 consomme plus d'électricité qu'elle n'en produit, et des valeurs négatives lorsque l'installation 6 produit plus d'électricité qu'elle n'en consomme.

Le capteur de courant 16 est, par exemple, un capteur à tore de Rogowsky. Le capteur de courant 16 est, par exemple, un capteur amovible apte à enserrer le conducteur 8 et à être fermé par clipsage.

De préférence, le capteur de courant 16 est auto-alimenté. Par exemple, le capteur de courant 16 est alimenté par récupération de l'énergie du courant électrique induit dans le capteur de courant 16 lors du passage du courant dans le conducteur 8.

Le capteur de courant 16 est configuré pour communiquer les valeurs de courant mesurées ou les valeurs de puissance calculées à l'appareil de détection 18. Par exemple, le capteur de courant 16 est apte à communiquer avec l'appareil de détection 18 par ondes radioélectriques. Le capteur de courant 16 utilise par exemple un protocole de communication ZigBee. En variante non représentée, le capteur de courant 16 est apte à communiquer avec l'appareil de détection 18 par liaison filaire.

L'appareil de détection 18 est configuré pour détecter la présence d'au moins un dispositif de production photovoltaïque d'électricité parmi le ou les dispositifs électriques 20 de l'installation 6 considérée à partir des mesures reçues du capteur de courant 16. De préférence, l'appareil de détection 18 est configuré pour détecter la présence d'au moins un dispositif de production photovoltaïque d'électricité parmi le ou les dispositifs électriques 20 d'une pluralité d'installations 6 considérées à partir des mesures reçues d'une pluralité de capteurs de courant 16.

L'appareil de détection 18comprend une unité de traitement d'informations 22A, formée par exemple d'une mémoire 22B et d'un processeur 22C associé à la mémoire 22B.

La mémoire 22B est apte à stocker un fichier de données contenant, pour chaque capteur de courant 16 associé à un conducteur 8, un identifiant du conducteur 8 et une information de puissance-crête d'un dispositif de production photovoltaïque d'électricité correspondant.

La mémoire 22B est également apte à stocker un logiciel 23d'acquisition de mesures de la part de chaque capteur de courant 16, un logiciel différentiel 24 configuré pour calculer la différence entre deux ensembles de mesures acquises, un logiciel de corrélation 26 configuré pour calculer un coefficient de corrélation entre les mesures acquises et un profil de référence, et un logiciel 28 de détection de la présence d'un dispositif de production photovoltaïque d'électricité parmi le ou les dispositifs électriques 20 de l'installation considérée.

En complément facultatif, la mémoire 22B est également apte à stocker un logiciel 30 d'estimation de la puissance crête d'un dispositif de production photovoltaïque d'électricité détecté.

Le processeur 22C est apte à exécuter chacun des logiciels d'acquisition 23, différentiel 24, de corrélation 26, de détection 28 et d'estimation 30. Les logiciels d'acquisition 23, différentiel 24, de corrélation 26, de détection 28 et d'estimation 30 forment, lorsqu'ils sont exécutés par le processeur 22C, respectivement un module d'acquisition de mesures, un module différentiel configuré pour calculer la différence entre deux ensembles de mesures acquises, un module de corrélation configuré pour calculer un coefficient de corrélation entre les mesures acquises et un profil de référence, un module de détection de la présence d'un dispositif de production photovoltaïque d'électricité, et un module d'estimation de la puissance crête d'un dispositif de production photovoltaïque d'électricité détecté.

En variante, le module d'acquisition 23, le module différentiel 24, le module de corrélation 26, le module de détection 28, et le module d'estimation 30 sont réalisés sous forme de composants logiques programmables, ou encore sous forme de circuits intégrés dédiés.

Sur la figure 1, l'appareil de détection 18 est intégré au poste de transformation MT/BT 4, et est alimenté en courant depuis le noeud 14. En variante non représentée, l'appareil de détection 18 est situé dans une installation dédiée, distante du poste de transformation 4.

Chaque départ triphasé 21 comporte quatre conducteurs 8 correspondant respectivement à une première phase, une deuxième phase, une troisième phase et au neutre en tension.

Le module d'acquisition 23 est apte à recevoir, de la part de chaque capteur de courant 16, une pluralité de profils de puissance active d'une installation correspondante, chaque profil de puissance active comportant une pluralité de mesures de puissance active associées chacune à un instant temporel respectif d'une plage temporelle.

En variante, le module d'acquisition 23 est configuré pour acquérir, de chaque capteur de courant 16, une pluralité de mesures de courant associées chacune à un instant temporel respectif d'une plage temporelle, puis pour calculer un profil de puissance active correspondant à partir d'une valeur connue de la tension. En variante, le module d'acquisition 23 est apte à recevoir une mesure de tension, puis à calculer le profil de puissance active correspondant à partir de la mesure de tension reçue.

Chaque profil de puissance active comporte une pluralité de composantes fréquentielles.

En complément facultatif, le module d'acquisition 23 est en outre configuré pour recevoir, de la part de chaque capteur de courant 16, une pluralité de profils de puissance réactive d'une installation correspondante, chaque profil de puissance réactive comportant une pluralité de mesures de puissance réactive associées chacune à un instant temporel respectif d'une plage temporelle. Par exemple, le module d'acquisition 23 est apte à calculer l'énergie réactive consommée par l'installation considérée pendant la plage temporelle correspondante. De préférence, chaque mesure de puissance réactive est effectuée en même temps qu'une mesure de puissance active d'un profil de puissance active correspondant, et le module d'acquisition 23 est apte à calculer l'énergie consommée par l'installation considérée pendant la plage temporelle d'un profil de puissance active correspondant.

En complément facultatif, le module d'acquisition 23 est configuré pour recevoir du dispositif de mesure de l'ensoleillement 17 une valeur de l'ensoleillement au niveau du poste de transformation MT/BT 4 pendant une plage temporelle. En variante, En complément facultatif, le module d'acquisition 23 est configuré pour recevoir d'une installation électronique distante (par exemple par Internet) une estimation de l'ensoleillement moyen au niveau du poste de transformation MT/BT 4 pendant une plage temporelle.

De préférence, chaque plage temporelle correspond à un jour de mesure respectif. De préférence, toutes les plages temporelles ont sensiblement la même durée. Par exemple, chaque plage temporelle dure 24 heures, et chaque plage temporelle correspond à un jour respectif. De préférence, chaque plage temporelle comprend une période diurne et une période nocturne.

De préférence, les mesures sont effectuées chaque jour à des instants temporels identiques. Par exemple, les mesures sont effectuées toutes les 1 à 10 minutes. De préférence, les jours de mesure sont consécutifs, afin de limiter l'influence de la variation saisonnière du climat et de la durée du jour. Par exemple, le module d'acquisition 23 est configuré pour recevoir du capteur de courant 16 un nombre prédéfinis de profils de puissance active correspondant chacun à un jour consécutif, correspondant à une période d'observation prédéfinie. La période d'observation est par exemple une période de deux semaines.

En complément facultatif, le module d'acquisition 23 comporte un filtre (non représenté) apte à filtrer les composantes fréquentielles de chaque profil de puissance reçu. De préférence, le filtre est un filtre passe-bas ayant une fréquence de coupure sensiblement égale à 3.10⁻⁴ Hz. Autrement dit, seules les composantes fréquentielles ayant une fréquence inférieure à 3.10⁻⁴ Hz sont conservées après filtrage.

De préférence, le module d'acquisition 23 comporte une mémoire, non représentée, de stockage d'une pluralité de profils de puissance acquis.

Le module d'acquisition 23 est en outre apte à transmettre chaque profil de puissance acquis au module différentiel 24.

Le module différentiel 24 est configuré pour recevoir une pluralité de profils de puissance active de la part du module d'acquisition 23 et calculer un profil différentiel pour au moins un couple de profils de puissance active. Chaque profil différentiel comporte une pluralité de valeurs, chaque valeur du profil différentiel étant égale à la différence entre deux mesures respectives des profils de puissance active dudit couple. De préférence, les plages temporelles respectives des profils de puissance active de chaque couple ont des durées sensiblement égales

Par exemple, le module différentiel 24 est configuré pour calculer un profil différentiel pour chacun des couples de profils de puissance active. Autrement dit, le module différentiel est configuré pour calculer un profil différentiel correspondant à l'association de chacun des profils de puissance active acquis avec chacun des autres profils de puissance active. De préférence, le module différentiel 24 est configuré pour sélectionner un ou plusieurs profils différentiels parmi les profils différentiels calculés.

Par exemple, le module différentiel 24 est configuré pour sélectionner uniquement les profils différentiels dont la valeur absolue maximale est supérieure à la moitié du maximum de l'ensemble des valeurs absolues des profils différentiels calculés.

En variante, le module différentiel 24 est configuré pour sélectionner uniquement les profils différentiels dont la valeur maximale de la valeur absolue correspond à un instant temporel compris entre deux instants temporels prédéfinis. Par exemple, pour des profils différentiels calculés à partir d'un couple de profils de puissance active mesurés en été, seuls les profils différentiels dont la valeur absolue est maximale entre 13 heures et 15 heures sont sélectionnés.

En complément facultatif, le module différentiel 24 est configuré pour sélectionner un couple de profils de puissance active parmi la pluralité de profils de puissance active, et pour calculer un profil différentiel à partir du couple de profils de puissance active sélectionné. De préférence, le module différentiel 24 est configuré pour sélectionner une pluralité de couples de profils de puissance active et calculer, pour chaque couple, un profil différentiel correspondant.

De préférence, le module différentiel 24 est configuré pour sélectionner un couple de profils de puissance active pour lesquels la consommation d'énergie électrique pour l'installation considérée est sensiblement égale, d'un profil du couple à l'autre profil, pendant la plage temporelle de mesure de chacun des deux profils dudit couple. Par exemple, le module différentiel 24 est configuré pour sélectionner uniquement les couples pour lesquels la consommation totale d'énergie réactive correspondant à l'un des profils du couple est sensiblement égale à la consommation totale d'énergie réactive correspondant à l'autre profil du couple. En variante ou en complément, le module différentiel 24 est configuré pour sélectionner seulement les couples pour lesquels la consommation totale d'énergie active pendant la période nocturne correspondant à l'un des profils du couple est sensiblement égale à la consommation totale d'énergie active pendant la période nocturne correspondant à l'autre profil du couple.

En variante ou en complément, le module différentiel 24 est configuré pour sélectionner un couple de profils de puissance active pour lesquels la production photovoltaïque d'électricité est différente. Par exemple, le module différentiel 24 est configuré pour sélectionner seulement les couples pour lesquels la valeur acquise d'ensoleillement diffère d'un profil à l'autre.

Le module différentiel 24 est propre à transmettre le ou les profils différentiels calculés au module de corrélation 26.

Le module de corrélation 26 est configuré pour calculer un coefficient de corrélation entre le ou les profils différentiels reçus et un profil de référence correspondant à une production photovoltaïque d'électricité. Le coefficient de corrélation est par exemple obtenu par un ajustement par la méthode des moindres carrés.

De préférence, le module de corrélation 26 est configuré, en cas d'une pluralité de profils différentiels calculés par le module différentiel 24, pour calculer un profil différentiel moyen égal à une moyenne des profils différentiels reçus, et pour calculer un coefficient de corrélation entre le profil différentiel moyen calculé et un profil de référence correspondant à une production photovoltaïque d'électricité. La moyenne est par exemple une moyenne arithmétique. En variante, la moyenne est une moyenne géométrique.

Le module de corrélation 26 est propre à transmettre le coefficient de corrélation calculé au module de détection 28.

Le module de détection 28 est configuré pour détecter un dispositif de production photovoltaïque d'électricité parmi le ou les dispositifs électriques de l'installation considérée 6 à partir du coefficient de corrélation calculé par le module de corrélation 26. Par exemple, le module de détection 28 est configuré pour comparer le coefficient de corrélation à une valeur prédéfinie, et pour détecter la présence d'un dispositif de production photovoltaïque d'électricité dans l'installation 6 considérée lorsque le coefficient de corrélation est supérieur à la valeur prédéfinie.

En complément facultatif, le module d'estimation 30 est configuré pour estimer la puissance crête de chaque dispositif de production photovoltaïque d'électricité détecté. Par exemple, le module d'estimation 30 est apte à recevoir, de la part du module de corrélation 26, les paramètres de l'ajustement réalisé. De préférence, le module d'estimation 30 est configuré pour calculer la puissance crête du dispositif de production photovoltaïque détecté ayant le profil de production correspondant aux paramètres de l'ajustement.

Le fonctionnement de l'appareil de détection 18 va maintenant être décrit à l'aide de la figure 2 représentant un organigramme du procédé de détection selon l'invention.

Lors d'une étape initiale 100, le module d'acquisition 23 reçoit pendant une période temporelle prédéfinie, par exemple quatorze jours consécutifs, un profil de puissance active d'un capteur de courant 16, qu'il stocke dans la mémoire. Chaque profil de puissance active comporte une pluralité de mesures de puissance active associées chacune à un instant temporel respectif d'une plage temporelle respective. Deux instants temporels consécutifs sont, par exemple, séparés d'une minute. Chaque plage temporelle dure 24 heures, de 0h à minuit, et comporte une période diurne et au moins une période nocturne. A chaque plage temporelle d'un profil de puissance active correspond un profil de puissance réactive respectif.

Lorsque les profils de puissance active et les profils de puissance réactive ont été acquis pour la période temporelle prédéfinie, le module d'acquisition 23 transmet les profils de puissance active et les profils de puissance réactive au module différentiel 24.

En complément facultatif, le module d'acquisition 23 filtre les composantes fréquentielles les plus élevées de chacun des profils de puissance active acquis. En particulier, le module d'acquisition 23 supprime les composantes dont la fréquence est supérieure à 3.10⁻⁴ Hz

La figure 3 présente deux profils différentiels 200, 210 calculés à partir de deux couples de profils non filtrés. La figure 4 présente deux profils différentiels 220, 230 calculés à partir de deux couples de profils filtrés.

Le module différentiel 24 sélectionne ensuite, lors de l'étape 110, un ou plusieurs couples de profils de puissance active parmi tous les profils de puissance active reçus.

Seul(s) le ou les couples pour lesquels la consommation totale d'énergie réactive correspondant à l'un des profils du couple est sensiblement égale à la consommation totale d'énergie réactive correspondant à l'autre profil du couple sont sélectionnés.

En variante ou en complément, seul(s) le ou les couples pour lesquels la consommation totale d'énergie active pendant la période nocturne correspondant à l'un des profils du couple est sensiblement égale à la consommation totale d'énergie active pendant la période nocturne correspondant à l'autre profil du couple.

En variante ou en complément, les couples de profils de puissance active pour lesquels la valeur acquise d'ensoleillement est sensiblement égale d'un profil à l'autre ne sont pas sélectionnés. Autrement dit, seuls les couples de profils de puissance correspondant à un ensoleillement différent sont sélectionnés.

En variante ou en complément, si l'un des deux profils de puissance active a été acquis pendant un jour travaillé alors que l'autre profil a été acquis pendant un jour chômé, alors le couple de profils n'est pas sélectionné. Autrement dit, seuls les couples dont les deux profils correspondent à un même type de jour parmi les jours travaillés et les jours chômés sont sélectionnés.

Le module différentiel 24 calcule alors pour chaque couple de profils sélectionnés un profil différentiel correspondant. Parmi ces profils différentiels calculés, le module différentiel 24 sélectionne alors, en complément facultatif, une pluralité de profils différentiels.

Seuls les profils différentiels dont la valeur absolue maximale est supérieure à la moitié du maximum de l'ensemble des valeurs absolues des profils différentiels calculés sont sélectionnés.

En variante ou en complément, seuls les profils différentiels dont la valeur maximale correspond à un instant temporel compris entre 12 h et 14 h en hiver, ou entre 13 h et 15 h en été, sont retenus. Trois profils différentiels satisfaisant à ce critère sont par exemple représentés en figure 5, avec les courbes 300, 310, 320.

Lors de l'étape 120, le module de corrélation 26 calcule un coefficient de corrélation entre le ou les profils différentiels calculés et un profil de référence correspondant à une production photovoltaïque d'électricité. Par exemple, le module de corrélation 26 effectue un ajustement entre le ou les profils différentiels calculés et ledit profil de référence par une méthode des moindres carrés. Le module de corrélation 26 détermine alors un ensemble de paramètres du profil de référence permettant le meilleur ajustement avec le profil différentiel moyen.

En variante ou en complément, en cas d'une pluralité de profils différentiels calculés par le module différentiel 24, le module de corrélation 26 calcule un profil différentiel moyen égal à la moyenne arithmétique des profils différentiels calculés, et calcule ensuite un coefficient de corrélation entre le profil différentiel moyen calculé et un profil de référence correspondant à une production photovoltaïque d'électricité.

Le module de détection 28 détecte ensuite lors de l'étape 130 la présence d'au moins un dispositif de production photovoltaïque d'électricité dans l'installation 6 reliée au câble 8 correspondant au capteur de courant 16 lorsque le coefficient de corrélation calculé lors de l'étape 120 est supérieur à une valeur prédéfinie.

Suite à l'étape de détection 130, le module d'estimation 30 estime lors de l'étape 140 la puissance crête du dispositif de production photovoltaïque d'électricité 20 détecté, s'il y en a un. Par exemple, le module d'estimation reçoit les paramètres déterminés lors de l'étape 120, et calcule à partir de ces paramètres la puissance crête d'un dispositif de production photovoltaïque permettant le meilleur ajustement avec le profil différentiel moyen.

Enfin, le fichier de données stocké dans la mémoire 22B est mise à jour lors d'une étape 150, pour faire correspondre à l'identifiant du capteur de courant considéré lors des étapes 100 à 140 la puissance crête estimée lors de l'étape 140. Si l'étape 130 n'a pas permis de détecter un dispositif de production photovoltaïque d'électricité, la puissance crête correspondante est alors fixée égale à 0.

Un autre capteur éventuel de courant est sélectionné lors de l'étape suivante 160, et les étapes 100 à 150 sont alors réitérées. Les étapes 100 à 150 sont donc réitérées dans cet ordre pour chacun des autres capteurs de courant 16 du réseau 2.

Ainsi, le procédé permet, pour chacune des installations électriques 6 du réseau 2, de détecter si l'installation comprend au moins un dispositif de production photovoltaïque d'électricité. Il permet également d'estimer la puissance crête de chacun des dispositifs de production photovoltaïque d'électricité détectés. Ce procédé permet donc de dimensionner au mieux le réseau 2 par une bonne évaluation des variations attendues de production photovoltaïque d'électricité. Il permet également d'ajuster la structure du réseau, par exemple de répartir au mieux les dispositifs de production photovoltaïque d'électricité sur les différentes phases d'un même départ 21. Il n'est pas nécessaire d'équiper chaque conducteur 8 d'un capteur de courant 16, le capteur de courant 16 étant déplaçable d'un conducteur 8 sur un autre conducteur 8 avant de réitérer les étapes 100 à 150.

En variante, l'étape 100 est réalisée simultanément pour tous les capteurs de courant 16 du réseau 2. Le module d'acquisition 23 reçoit alors chaque jour un profil de puissance active de chacun des capteurs 16. Lorsque chaque capteur 16 a fourni l'ensemble des profils de puissance active pour la période temporelle prédéfinie au module d'acquisition 23, les étapes 110 à 130 sont alors effectuées pour chaque ensemble de profils de puissance active associé à chaque capteur.

Le procédé permet alors de minimiser le temps nécessaire à l'acquisition des mesures.

En variante, 60 profils de puissance active correspondant à deux mois de mesure sont acquis lors de l'étape 100. Dans ce cas, tous les couples dont les deux profils ont été acquis à plus de 14 jours d'écart sont rejetés lors de l'étape 110.

Le procédé permet alors une plus grande précision de détection grâce au plus grand échantillon utilisé, tout en limitant l'influence de la variation saisonnière d'ensoleillement.

En variante encore, le procédé est répété chaque jour sur tous les capteurs de courant 16 du réseau 2. Dans ce cas, tous les profils de puissance active ayant été acquis plus de 14 jours auparavant sont rejetés lors de l'étape 110.

Ce procédé permet donc de surveiller en continu l'évolution du réseau 2, et de détecter automatiquement l'ajout d'un nouveau dispositif de production photovoltaïque dans une installation électrique 6 correspondante du réseau 2.

## Revendications

1. Procédé de détection d'au moins un dispositif de production photovoltaïque d'électricité dans un réseau (2) de distribution électrique comprenant au moins une installation électrique (6) et au moins un capteur de courant (16), chaque installation (6) comprenant au moins un dispositif électrique (20) et étant reliée à un noeud de distribution (14) respectif par au moins un conducteur électrique (8) respectif, chaque capteur (16) étant associé à un conducteur électrique (8) respectif,
le procédé étant **caractérisé en ce qu'**il comprend les étapes suivantes :
i/ acquisition (100), de la part d'un capteur de courant (16), d'une pluralité de profils de puissance active d'une installation (6) correspondante, chaque profil de puissance active comportant une pluralité de mesures de puissance active associées chacune à un instant temporel respectif d'une plage temporelle ;
ii/ calcul (110), pour au moins un couple de profils de puissance active, d'un profil différentiel comportant une pluralité de valeurs, chaque valeur du profil différentiel étant égale à la différence entre deux mesures respectives des profils de puissance active dudit couple ;
iii/ calcul (120) d'un coefficient de corrélation entre le ou les profils différentiels calculés et un profil de référence correspondant à une production photovoltaïque d'électricité ;
iv/ détection (130) de la présence d'un dispositif de production photovoltaïque d'électricité parmi le ou les dispositifs électriques (20) de l'installation (6) considérée lorsque le coefficient de corrélation est supérieur à une valeur prédéfinie.

2. Procédé selon la revendication 1, dans lequel les plages temporelles respectives des profils de puissance active de chaque couple ont des durées sensiblement égales.

3. Procédé selon l'une quelconque des revendications précédentes, dans lequel l'étape ii/ comprend la sélection, parmi la pluralité de profils acquis, d'un couple de profils pour lesquels la consommation d'énergie électrique par l'installation (6) considérée est sensiblement égale, d'un profil du couple à l'autre, pendant la plage temporelle de mesure de chacun des deux profils dudit couple, et le calcul du profil différentiel est effectué à partir du couple sélectionné de profils.

4. Procédé selon la revendication 3, dans lequel l'étape i/ comprend en outre l'acquisition d'une pluralité de profils de puissance réactive, chaque profil de puissance réactive comportant une pluralité de mesures de puissance réactive associées chacune à un instant temporel respectif de la plage temporelle d'un profil de puissance active correspondant, et le calcul à partir de chaque profil de puissance réactive de l'énergie réactive consommée pendant la plage temporelle correspondante, et
dans lequel la sélection d'au moins un couple de profils effectuée lors de l'étape ii/ comprend la sélection d'un couple de profils pour lesquels la consommation totale d'énergie réactive correspondant à l'un des profils du couple est égale, à 10% près, à la consommation totale d'énergie réactive correspondant à l'autre profil du couple.

5. Procédé selon l'une quelconque des revendications 3 ou 4, dans lequel la plage temporelle correspondant à chaque profil de puissance active comprend une période diurne et une période nocturne, et
dans lequel la sélection d'au moins un couple de profils effectuée lors de l'étape ii/ comprend la sélection d'un couple de profils pour lesquels la consommation totale d'énergie active pendant la période nocturne correspondant à l'un des profils du couple est égale, à 10% près, à la consommation totale d'énergie active pendant la période nocturne correspondant à l'autre des profils du couple.

6. Procédé selon l'une quelconque des revendications précédentes, dans lequel l'étape i/ comprend en outre l'acquisition d'une valeur d'ensoleillement lors de la mesure de chaque profil de puissance active, et
l'étape ii/ comprend la sélection, parmi la pluralité de profils acquis de puissance active, d'au moins un couple de profils pour lesquels la valeur acquise d'ensoleillement diffère d'un profil à l'autre, et le calcul du profil différentiel est effectué à partir du couple sélectionné de profils.

7. Procédé selon l'une quelconque des revendications précédentes, dans lequel l'étape ii/ comprend le calcul d'un profil différentiel pour chaque couple de profils de puissance active, et la sélection d'au moins un profil différentiel dont la valeur absolue maximale est supérieure à la moitié du maximum de l'ensemble des valeurs absolues des profils différentiels calculés, et
lors de l'étape iii/, le calcul du coefficient de corrélation est effectué en fonction du ou des profils différentiels sélectionnés.

8. Procédé selon l'une quelconque des revendications précédentes , dans lequel l'étape ii/ comprend le calcul d'au moins un profil différentiel pour chaque couple de profils de puissance active, et la sélection d'un profil différentiel dont la valeur absolue présente une valeur maximale pour un instant temporel compris entre deux instants temporels prédéfinis, et
lors de l'étape iii/, le calcul du coefficient de corrélation est effectué en fonction du ou des profils différentiels sélectionnés.

9. Procédé selon l'une quelconque des revendications précédentes, dans lequel, lorsque plusieurs profils différentiels sont calculés lors de l'étape ii/, l'étape iii/ comprend en outre le calcul d'un profil différentiel moyen égal à une moyenne des profils différentiels calculés, et le coefficient de corrélation est calculé entre le profil différentiel moyen et le profil de référence correspondant à la production photovoltaïque d'électricité.

10. Procédé selon l'une quelconque des revendications précédentes, dans lequel lors de l'étape i/, chaque profil de puissance active comporte des composantes fréquentielles, et les composantes fréquentielles de chaque profil de puissance active d'au moins un couple sont filtrées par un filtre passe-bas ayant une fréquence de coupure sensiblement égale à 3.10⁻⁴ Hz, et le calcul du profil différentiel est effectué à partir du couple filtré de profils.

11. Procédé selon l'une quelconque des revendications précédentes, comprenant en outre une étape d'estimation de la puissance crête d'un dispositif de production photovoltaïque d'électricité détecté à partir du profil différentiel calculé.

12. Procédé selon l'une quelconque des revendications précédentes, dans lequel les étapes i/ à iv/ sont réitérées à partir des profils de puissance active acquis de la part d'un autre capteur de courant (16).

13. Produit programme d'ordinateur comportant des instructions logicielles qui, lorsqu'elles sont exécutées par un ordinateur, mettent en oeuvre un procédé selon l'une quelconque des revendications précédentes.

14. Appareil (18) de détection d'au moins un dispositif de production photovoltaïque d'électricité dans un réseau (2) de distribution électrique comprenant au moins une installation électrique (6) et au moins un capteur de courant (16), chaque installation (6) comprenant au moins un dispositif électrique (20) et étant reliée à un noeud de distribution (14) respectif par au moins un conducteur électrique (8) respectif, chaque capteur (16) étant associé à un conducteur électrique (8) respectif, l'appareil de détection (18) étant **caractérisé en ce qu'**il comprend :
- un module d'acquisition (23) configuré pour acquérir, de la part d'un capteur de courant (16), une pluralité de profils de puissance active d'une installation (6) correspondante, chaque profil de puissance active comportant une pluralité de mesures de puissance active associées chacune à un instant temporel respectif d'une plage temporelle ;
- un module différentiel (24) configuré pour calculer, pour au moins un couple de profils de puissance active, un profil différentiel comportant une pluralité de valeurs, chaque valeur du profil différentiel étant égale à la différence entre deux mesures respectives des profils de puissance active dudit couple;
- un module de corrélation (26) configuré pour calculer un coefficient de corrélation entre le ou les profils différentiels calculés et un profil de référence correspondant à une production photovoltaïque d'électricité ; et
- un module de détection (28) configuré pour détecter la présence d'un dispositif de production photovoltaïque d'électricité parmi le ou les dispositifs électriques (20) de l'installation (6) considérée lorsque le coefficient de corrélation est supérieur à une valeur prédéfinie.

15. Appareil de détection (18) selon la revendication 14, comprenant en outre un module d'estimation (30) configuré pour estimer la puissance crête d'un dispositif détecté de production photovoltaïque d'électricité à partir du profil différentiel calculé.

## Patentansprüche

1. Verfahren zum Detektieren mindestens einer Vorrichtung zur photovoltaischen Erzeugung von Strom in einem elektrischen Verteilernetz (2), das mindestens eine elektrische Anlage (6) und mindestens einen Stromsensor (16) umfasst, wobei jede Anlage (6) mindestens eine elektrische Vorrichtung (20) umfasst und durch mindestens einen jeweiligen elektrischen Leiter (8) an einen Verteilungsknoten (14) angeschlossen ist, wobei jeder Sensor (16) einem jeweiligen elektrischen Leiter (8) zugeordnet ist,
wobei das Verfahren **dadurch gekennzeichnet ist, dass** es die folgenden Schritte umfasst:
i/ Beschaffen (100) einer Mehrzahl von Wirkleistungsprofilen einer korrespondierenden Anlage (6) seitens des Stromsensors (16), wobei jedes Wirkleistungsprofil eine Mehrzahl von Wirkleistungsmessungen aufweist, die jeweils einem jeweiligen Zeitpunkt eines Zeitbereichs zugeordnet sind;
ii/ für mindestens ein Paar von Wirkleistungsprofilen Berechnen (110) eines Differenzprofils, das eine Mehrzahl von Werten aufweist, wobei jeder Wert des Differenzprofils gleich der Differenz zwischen zwei jeweiligen Messungen der Wirkleistungsprofile des Paares ist;
iii/ Berechnen (120) eines Korrelationskoeffizienten zwischen dem oder den berechneten Differenzprofilen und einem Referenzprofil, das einer photovoltaischen Stromerzeugung entspricht;
iv/ Detektieren (130) des Vorhandenseins einer Vorrichtung zur photovoltaischen Stromerzeugung unter der oder den elektrischen Vorrichtungen (20) der betrachteten Anlage (6), wenn der Korrelationskoeffizient größer als ein vorbestimmter Wert ist.

2. Verfahren nach Anspruch 1, bei dem die jeweiligen Zeitbereiche der Wirkleistungsprofile jedes Paares im Wesentlichen gleich sind.

3. Verfahren nach einem beliebigen der vorhergehenden Ansprüche, bei dem der Schritt ii/ das Auswählen eines Profilpaares aus der Mehrzahl von beschafften Profilen umfasst, für die der Verbrauch an elektrischer Energie pro berücksichtigter Anlage (6) von einem Profil des Paares zum anderen während des Zeitbereichs der Messung jedes der zwei Profile des Paares im Wesentlichen gleich ist, und das Berechnen des Differenzprofils aus dem ausgewählten Paar von Profilen durchgeführt wird.

4. Verfahren nach Anspruch 3, bei dem der Schritt i/ außerdem das Beschaffen einer Mehrzahl von Blindleistungsprofilen umfasst, wobei jedes Blindleistungsprofil eine Mehrzahl von Blindleistungsmessungen aufweist, die jeweils einem jeweiligen Zeitpunkt des Zeitbereichs eines entsprechenden Blindleistungsprofils zugeordnet sind, und das Berechnen der verbrauchten Blindenergie während des entsprechenden Zeitbereichs aus jedem Blindleistungsprofil umfasst, und
bei dem das Auswählen mindestens eines Profilpaares, das während des Schritts ii/ durchgeführt wird, das Auswählen eines Paares an Profilen umfasst, für die der gesamte Verbrauch an Blindenergie, der einem der Profile des Paares entspricht, auf 10% genau gleich dem gesamten Verbrauch an Blindenergie ist, der dem anderen Profil des Paares entspricht.

5. Verfahren nach einem beliebigen der Ansprüche 3 oder 4, bei dem der Zeitbereich, der jedem Wirkleistungsprofil entspricht, eine Tagperiode und eine Nachtperiode umfasst, und
bei dem das Auswählen mindestens eines Profilpaares, das während des Schrittes ii/ durchgeführt wird, das Auswählen eines Paares an Profilen umfasst, für die der gesamte Verbrauch an Wirkenergie während der Nachtperiode, der einem der Profile des Paares entspricht, auf 10% genau gleich dem gesamten Verbrauch an Wirkenergie während der Nachtperiode ist, der dem anderen der Profile des Paares entspricht.

6. Verfahren nach einem beliebigen der vorhergehenden Ansprüche, bei dem der Schritt i/ außerdem das Beschaffen eines Sonnenscheinwerts bei der Messung jedes Wirkleistungsprofils umfasst, und
der Schritt ii/ aus der Mehrzahl von beschafften Wirkleistungsprofilen das Auswählen mindestens eines Paares von Profilen umfasst, für die der beschaffte Sonnenscheinwert sich von einem Profil zum anderen unterscheidet, und das Berechnen des Differenzprofils aus dem ausgewählten Paar von Profilen durchgeführt wird.

7. Verfahren nach einem beliebigen der vorhergehenden Ansprüche, bei dem der Schritt ii/ das Berechnen eines Differenzprofils für jedes Paar von Wirkleistungsprofilen und das Auswählen mindestens eines Differenzprofils umfasst, dessen maximaler Absolutwert größer ist als die Hälfte des Maximums der Gesamtheit der Absolutwerte der berechneten Differenzprofile, und
bei dem Schritt iii/ das Berechnen des Korrelationskoeffizienten abhängig von dem oder den ausgewählten Differenzprofilen durchgeführt wird.

8. Verfahren nach einem beliebigen der vorhergehenden Ansprüche, bei dem der Schritt ii/ das Berechnen mindestens eines Differenzprofils für jedes Wirkleistungsprofil und das Auswählen eines Differenzprofils umfasst, dessen Absolutwert einen Maximalwert für einen Zeitpunkt, der zwischen zwei vorbestimmten Zeitpunkten liegt, aufweist, und
bei dem Schritt iii/ das Berechnen des Korrelationskoeffizienten abhängig von dem oder den ausgewählten Differenzprofilen durchgeführt wird.

9. Verfahren nach einem beliebigen der vorhergehenden Ansprüche, bei dem, wenn mehrere Differenzprofile während des Schritts ii/ berechnet werden, der Schritt iii/ außerdem das Berechnen eines mittleren Differenzprofils gleich einem Mittelwert der berechneten Differenzprofile umfasst, und der Korrelationskoeffizient zwischen dem mittleren Differenzprofil und dem Referenzprofil, das der photovoltaischen Stromerzeugung entspricht, berechnet wird.

10. Verfahren nach einem beliebigen der vorhergehenden Ansprüche, bei dem während des Schrittes i/jedes Wirkleistungsprofil Frequenzkomponenten aufweist und die Frequenzkomponenten jedes Wirkleistungsprofils mindestens eines Paares durch ein Tiefpassfilter, das eine Grenzfrequenz von im Wesentlichen gleich 3·10⁻⁴ Hz aufweist, gefiltert werden, und das Berechnen des Differenzprofils aus dem gefilterten Paar von Profilen durchgeführt wird.

11. Verfahren nach einem beliebigen der vorhergehenden Ansprüche, außerdem einen Schritt des Schätzens einer Spitzenleistung einer Vorrichtung zur photovoltaischen Stromerzeugung, die aus dem berechneten Differenzprofil detektiert wird, umfasst.

12. Verfahren nach einem beliebigen der vorhergehenden Ansprüche, bei dem die Schritte i/ bis iv/ aus Wirkleistungsprofilen, die seitens eines anderen Stromsensors (16) beschafft werden, wiederholt werden.

13. Computerprogrammprodukt, das Softwarebefehle aufweist, die, wenn sie von einem Computer ausgeführt werden, ein Verfahren nach einem der vorhergehenden Ansprüche durchführen.

14. Gerät (18) zum Detektieren mindestens einer Vorrichtung zur photovoltaischen Stromerzeugung in einem elektrischen Verteilernetz (2), das mindestens eine elektrische Anlage (6) und mindestens einen Stromsensor (16) umfasst, wobei jede Anlage mindestens eine elektrische Vorrichtung (20) umfasst, und an einen jeweiligen Verteilungsknoten (14) über mindestens einen jeweiligen elektrischen Leiter (8) angeschlossen ist, wobei jeder Sensor einem jeweiligen elektrischen Leiter (8) zugeordnet ist, wobei das Detektionsgerät (18) **dadurch gekennzeichnet ist, dass** es umfasst:
- ein Beschaffungsmodul (23), das ausgebildet ist, seitens des Stromsensors (16) eine Mehrzahl von Wirkleistungsprofilen einer entsprechenden Anlage (6) zu beschaffen, wobei jedes Wirkleistungsprofil eine Mehrzahl von Wirkleistungsmessungen aufweist, die jeweils einem jeweiligen Zeitpunkt eines Zeitbereichs zugeordnet sind;
- ein Differenzmodul (24), das ausgebildet ist, für mindestens ein Paar von Wirkleistungsprofilen ein Differenzprofil zu berechnen, das eine Mehrzahl von Werten aufweist, wobei jeder Wert des Differenzprofils gleich der Differenz zwischen zwei jeweiligen Messungen der Wirkleistungsprofile des Paares ist;
- ein Korrelationsmodul (26), das ausgebildet ist, einen Korrelationskoeffizienten zwischen dem oder den berechneten Differenzprofilen und einem Referenzprofil, das einer photovoltaischen Stromerzeugung entspricht, zu berechnen; und
- ein Detektionsmodul (28), das ausgebildet ist, das Vorhandensein einer Vorrichtung zur photovoltaischen Stromerzeugung aus dem oder den elektrischen Vorrichtungen (20) der betrachteten Anlage (6) zu detektieren, wenn der Korrelationskoeffizient größer als ein vorbestimmter Wert ist.

15. Gerät (18) zur Detektion nach Anspruch 14, außerdem ein Schätzmodul (30) umfassend, das ausgebildet ist, die Spitzenleistung einer detektierten Vorrichtung zur photovoltaischen Stromerzeugung aus dem berechneten Differenzprofil zu schätzen.

## Claims

1. Method for detecting at least one photovoltaic electricity production device in an electricity distribution network (2) comprising at least one electrical installation (6) and at least one current sensor (16), each installation (6) comprising at least one electrical device (20) and being connected to a respective distribution node (14) by at least one respective electrical conductor (8), each sensor (16) being associated with a respective electrical conductor (8),
the method being **characterised in that** it comprises the following steps:
i/ acquisition (100), by a current sensor (16), of a plurality of active power profiles of a corresponding installation (6), each active power profile comprising a plurality of active power measurements each associated with a respective time instant of a time range;
ii/ calculation (110), for at least one pair of active power profiles, of a differential profile comprising a plurality of values, each value of the differential profile being equal to the difference between two respective measurements of the active power profiles of said pair;
iii/ calculation (120) of a correlation coefficient between the calculated differential profile or profiles and a reference profile corresponding to a photovoltaic electricity production;
iv/ detection (130) of the presence of a photovoltaic electricity production device among the electrical device or devices (20) of the installation (6) in question when the correlation coefficient is greater than a predefined value.

2. Method according to claim 1, wherein the respective time ranges of the active power profiles of each pair have substantially equal durations.

3. Method according to any one of the preceding claims, wherein step ii/ comprises the selection, from among the plurality of acquired profiles, of a pair of profiles for which the electrical energy consumption by the installation (6) in question is substantially equal, from one profile of the pair to the other, during the measurement time range of each of the two profiles of said pair, and calculation of the differential profile is carried out on the basis of the selected pair of profiles.

4. Method according to claim 3, wherein step i/ further comprises the acquisition of a plurality of reactive power profiles, each reactive power profile comprising a plurality of reactive power measurements each associated with a respective time instant of the time range of a corresponding active power profile, and calculation, on the basis of each reactive power profile, of the reactive energy consumed during the corresponding time range, and
wherein the selection of at least one pair of profiles carried out in step ii/ comprises the selection of a pair of profiles for which the total reactive energy consumption corresponding to one of the profiles of the pair is equal, to within 10%, to the total reactive energy consumption corresponding to the other profile of the pair.

5. Method according to either claim 3 or claim 4, wherein the time range corresponding to each active power profile comprises a diurnal period and a nocturnal period, and
wherein the selection of at least one pair of profiles carried out in step ii/ comprises the selection of a pair of profiles for which the total active energy consumption during the nocturnal period corresponding to one of the profiles of the pair is equal, to within 10%, to the total active energy consumption during the nocturnal period corresponding to the other of the profiles of the pair.

6. Method according to any one of the preceding claims, wherein step i/ further comprises the acquisition of an insolation value during the measurement of each active power profile, and
step ii/ comprises the selection, from among the plurality of acquired active power profiles, of at least one pair of profiles for which the acquired insolation value differs from one profile to the other, and calculation of the differential profile is carried out on the basis of the selected pair of profiles.

7. Method according to any one of the preceding claims, wherein step ii/ comprises the calculation of a differential profile for each pair of active power profiles, and the selection of at least one differential profile whose absolute maximum value is greater than half the maximum of the set of absolute values of the calculated differential profiles, and
in step iii/, the calculation of the correlation coefficient is carried out as a function of the selected differential profile or profiles.

8. Method according to any one of the preceding claims, wherein step ii/ comprises the calculation of at least one differential profile for each pair of active power profiles, and the selection of a differential profile whose absolute value has a maximum value for a time instant between two predefined time instants, and
in step iii/, the calculation of the correlation coefficient is carried out as a function of the selected differential profile or profiles.

9. Method according to any one of the preceding claims, wherein, when a plurality of differential profiles are calculated in step ii/, step iii/ further comprises the calculation of an average differential profile equal to an average of the calculated differential profiles, and the correlation coefficient is calculated between the average differential profile and the reference profile corresponding to the photovoltaic electricity production.

10. Method according to any one of the preceding claims, wherein in step i/ each active power profile comprises frequency components, and the frequency components of each active power profile of at least one pair are filtered by a lowpass filter having a cut-off frequency substantially equal to 3.10⁻⁴ Hz, and the calculation of the differential profile is carried out on the basis of the filtered pair of profiles.

11. Method according to any one of the preceding claims, further comprising a step of estimation of the peak power of a detected photovoltaic electricity production device on the basis of the calculated differential profile.

12. Method according to any one of the preceding claims, wherein steps i/ to iv/ are repeated on the basis of the active power profiles acquired by another current sensor (16).

13. Computer program product comprising software instructions which, when executed by a computer, implement a method according to any one of the preceding claims.

14. Apparatus (18) for detecting at least one photovoltaic electricity production device in an electricity distribution network (2) comprising at least one electrical installation (6) and at least one current sensor (16), each installation (6) comprising at least one electrical device (20) and being connected to a respective distribution node (14) by at least one respective electrical conductor (8), each sensor (16) being associated with a respective electrical conductor (8), the detection apparatus (18) being **characterised in that** it comprises:
- an acquisition module (23) configured to acquire, by a current sensor (16), a plurality of active power profiles of a corresponding installation (6), each active power profile comprising a plurality of active power measurements each associated with a respective time instant of a time range;
- a differential module (24) configured to calculate, for at least one pair of active power profiles, a differential profile comprising a plurality of values, each value of the differential profile being equal to the difference between two respective measurements of the active power profiles of said pair;
- a correlation module (26) configured to calculate a correlation coefficient between the calculated differential profile or profiles and a reference profile corresponding to a photovoltaic electricity production; and
- a detection module (28) configured to detect the presence of a photovoltaic electricity production device among the electrical device or devices (20) of the installation (6) in question when the correlation coefficient is greater than a predefined value.

15. Detection apparatus (18) according to claim 14, further comprising an estimation module (30) configured to estimate the peak power of a detected photovoltaic electricity production device on the basis of the calculated differential profile.
